# EUROPÄISCHE PATENTANMELDUNG

(11) **EP 2 164 106 A1**
(43) Veröffentlichungstag der Anmeldung: **17.03.2010**
(21) Anmeldenummer: 09169446.3
(22) Anmeldetag: 04.09.2009
(51) Int. Cl.: H01L 31/0224, H01L 31/18

(54) **Verfahren und Vorrichtung zum Aufbringen eines länglichen Leiters auf ein Solarelement**

(30) Priorität: 11.09.2008 EP 08164185
(71) Anmelder: Komax Holding AG, 6036 Dierikon (CH)
(72) Erfinder: Hofmann, Dominik, 6353, Weggis (CH); Hofer, Adolf, 8426, Lufingen (CH); Murer, Stefan, 6375, Beckenried (CH)
(74) Vertreter: Blöchle, Hans

(57) **Zusammenfassung**

Verfahren und Vorrichtung zum Aufbringen eines länglichen elektrischen Leiters (2) auf ein Solarelement (1). Es wird die erforderlichen Länge des länglichen elektrischen Leiters (2) bereitgestellt und der Leiter (2) durch das Aufbringen einer Zugspannung gereckt. Dann wird der Leiter (2) befestigt. Das Recken des länglichen elektrischen Leiters (2) wird überwacht, um das Überschreiten einer Zuggrenze zu verhindern. Beim Befestigen auf dem Solarelement (1) kommt mindestens eine Andrückrolle zum Einsatz.

## Beschreibung

Die Erfindung betrifft ein Verfahren und Vorrichtung zum Aufbringen eines länglichen Leiters auf ein Solarelement.

Kristalline Solarzellen werden gemäss einem vorbekannten Verfahren auf der Vorderseite mit Leiterbändern kontaktiert. Gemäss der Offenlegungsschrift DE 10 2006 006 715 A1, werden Greifer eingesetzt, um ein Leiterband zu greifen und kontrolliert auf die Solarzellen zu platzieren. Dann wird das Leiterband mit einer Längsspannung beaufschlagt, bevor es auf den Solarzellen befestigt wird. Vor dem Durchtrennen des Leiterbandes und vor dem Befestigen auf den Solarzellen, wird das Leiterband durch ein Niederhaltersystem an die Solarzellen geklemmt. Das Befestigen des Leiterbandes geschieht in diesem Beispiel mittels eines Klebstoffs.

Dieser Ansatz eignet sich aber nicht für DünnschichtSolarzellen und für Solarelemente, die grössere Dimensionen haben als die kristallinen Solarzellen. Bei grösseren Dimensionen sind die Anforderungen an die Genauigkeit der Platzierung des Leiterbandes deutlich höher. Ausserdem spielen bei grösseren Dimensionen, die einher gehen mit längeren Leiterbändern, auch die Welligkeit und etwaige Wölbungen des Leiterbandes eine immer grössere Rolle. Weiterhin ist es wichtig sicher zu stellen, dass die Leiterbänder trotz der grösseren Länge einen möglichst konstanten Übergangswiderstand zu dem Solarelement aufweisen. Etwaige Fehlausrichtungen verursachen Leistungsverluste.

Wird das Leiterband gedehnt, so kann sich eine Verfestigung des Leiterbandes ergeben. Diese Verfestigung kann zu einer Beschädigung der Kristalle einer kristallinen Solarzelle führen. Dünnschichtsolarzellen können auch durch das Leiterband beschädigt werden, wenn es nicht mit entsprechender Vorsicht aufgebracht wird. Das Dehnen des Leiterbandes kann auch zu einer Versprödung führen und es können dadurch Mikrorisse entstehen, die unerwünscht sind.

Es stellt sich daher die Aufgabe ein Verfahren zum Kontaktieren von Solarelementen mit einem länglichen Leiter zu entwickeln, das die eingangs genannten Nachteile vermeidet. Das Verfahren sollte zuverlässig und reproduzierbar funktionieren und es sollte sich vor allem für das Aufbringen von Leitern eignen, die länger sind als 300 mm.

Ausserdem ist es eine Aufgabe der Erfindung eine entsprechende Vorrichtung bereit zu stellen, die es ermöglicht, das Verfahren automatisiert auszuführen.

Ein erfindungsgemässes Verfahren ist dem Anspruch 1 zu entnehmen und eine erfindungsgemässe Vorrichtung dem Anspruch 10.

Vorteilhafte Weiterbildungen des erfindungsgemässen Verfahrens und der erfindungsgemässen Vorrichtung sind durch die abhängigen Patentansprüche definiert.

Es wird als ein Vorteil der Erfindung angesehen, dass durch das spezielle Verfahren und die entsprechend ausgelegte Vorrichtung homogene, niederohmige Kontaktierungen auch über grössere Wegstrecken möglich sind.

Weitere Vorteile sind das knitter- oder faltenfreie Aufbringen langer Leiterbahnen, die hohe Genauigkeit und hervorragende Reproduzierbarkeit, sowie das Sicherstellen eines gleichmässigen Übergangswiderstandes zwischen dem länglichen Leiter und dem Solarelement.

Im Folgenden wird die Erfindung anhand von Ausführungsbeispielen und mit Bezug auf die Figuren ausführlich beschrieben. Es zeigen:
- Fig. 1: eine erfindungsgemässe Verarbeitungsanlage in einer perspektivischen Ansicht;
- Fig. 2: eine 2. Station der erfindungsgemässen Verarbeitungsanlage in einer perspektivischen Ansicht;
- Fig. 3: eine perspektivische Ansicht einer Bandzuführung der erfindungsgemässen Verarbeitungsanlage;
- Fig. 4A: eine perspektivische Ansicht einer Schneid/Klemmeinheit der erfindungsgemässen Verarbeitungsanlage;
- Fig. 4B: eine Schnittansicht der Schneid-/Klemmeinheit nach Fig. 4A;
- Fig. 5: eine perspektivische Ansicht eines Auszugsschlittens der erfindungsgemässen Verarbeitungsanlage;
- Fig. 6: eine perspektivische Ansicht eines Anrollschlittens der erfindungsgemässen Verarbeitungsanlage;
- Fig. 7A: einen ersten Schritt eines erfindungsgemässen Verfahrens in einer Schnittansicht;
- Fig. 7B: einen zweiten Schritt eines erfindungsgemässen Verfahrens in einer Schnittansicht;
- Fig. 7C: eine Ausschnittvergrösserung von Fig. 7B;
- Fig. 7D: einen weiteren Schritt eines erfindungsgemässen Verfahrens in einer Schnittansicht;
- Fig. 7E: einen weiteren Schritt eines erfindungsgemässen Verfahrens in einer perspektivischen Ansicht;
- Fig. 7F: einen weiteren Schritt eines erfindungsgemässen Verfahrens in einer Schnittansicht;
- Fig. 7G: einen weiteren Schritt eines erfindungsgemässen Verfahrens in einer perspektivischen Ansicht;
- Fig. 7H: einen weiteren Schritt eines erfindungsgemässen Verfahrens in einer Schnittansicht;
- Fig. 7I: einen weiteren Schritt eines erfindungsgemässen Verfahrens in einer Schnittansicht;
- Fig. 7J: einen weiteren Schritt eines erfindungsgemässen Verfahrens in einer Schnittansicht;
- Fig. 7K: einen weiteren Schritt eines erfindungsgemässen Verfahrens in einer Schnittansicht;
- Fig. 8: einen schematischen Schnitt durch ein Solarelement mit zwei Leitern;
- Fig. 9: eine schematische Draufsicht eines Solarelements mit zwei Leitern.

Es geht bei der vorliegenden Erfindung um einen Teilaspekt der Herstellung von Solarelementen. Der Begriff Solarelement wird hier als Oberbegriff für Solarzellen, Solarmodule und Solaranlagen verwendet. Die Erfindung ist davon unabhängig, ob es sich um kristalline, polykristalline oder amorphe Solarelemente handelt. Die Erfindung lässt sich besonders vorteilhaft anwenden auf Dünnschicht-Solarelemente. Die Anwendung der Erfindung ist nicht beschränkt auf Siliziumsolarzellen. Sie lässt sich auch auf andere Solarzellentypen (z.B. organische Solarzellen) anwenden.

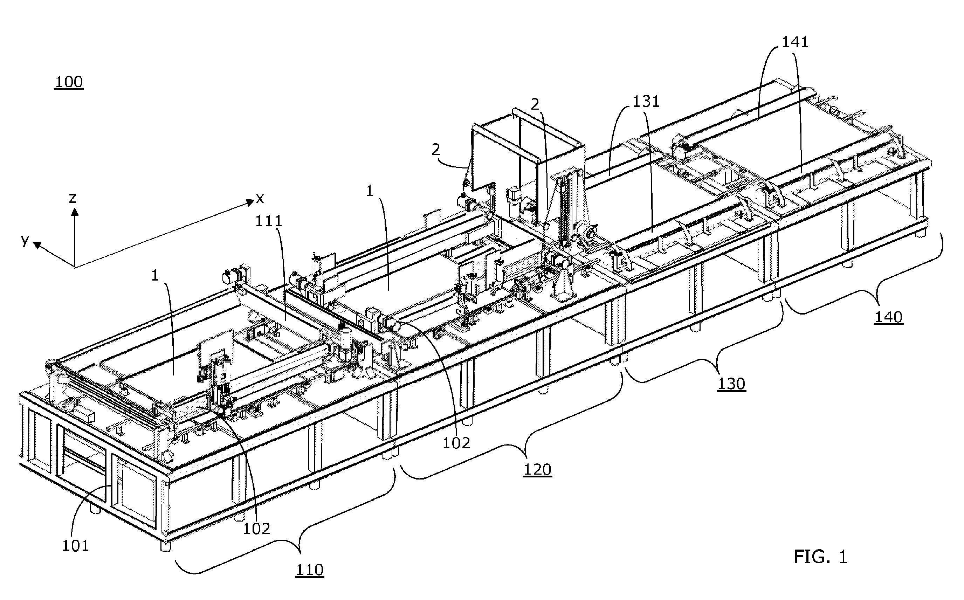

Typischerweise wird mindestens ein Teil der Herstellschritte in einer automatisierten Verarbeitungsanlage 100 durchgeführt. Eine entsprechende Verarbeitungsanlage 100 gemäss einer ersten Ausführungsform der Erfindung ist in Fig. 1 gezeigt. Die Solarelemente 1 durchlaufen die Verarbeitungsanlage 100 von links nach rechts (in x-Richtung) und werden durch Förderanlagen 102 in x-Richtung bewegt. Als Unterbau umfasst die Verarbeitungsanlage 100 ein Gestell, das im Folgenden zusammenfassen als Rahmen 101 bezeichnet wird. Dieser Rahmen 101 kann auf einem Unterboden stehen und trägt die Elemente der Verarbeitungsanlage 100, wie in Fig. 1 gezeigt. Im gezeigten Beispiel umfasst die Verarbeitungsanlage 100 eine 1. Station 110, eine 2. Station 120, eine 3. Station 130 und eine 4. Station 140.

Die 1. Station 110 ist dazu ausgelegt über einen Dispenser 111 einen Spezialklebstoff in einer, zwei oder mehr parallelen Bahnen auf die Solarelemente 1 aufzutragen. Die Anzahl der Klebstoffbahnen richtet sich nach der Anzahl der parallelen länglichen Leiter, die auf die Solarelemente 1 aufgebracht werden sollen. In Fig. 1 ist eine Verarbeitungsanlage 100 gezeigt, bei der zwei parallele Klebstoffbahnen und zwei parallele längliche Leiter 2 aufgebracht werden.

Der Spezialklebstoff ist so ausgelegt, dass er entweder bereits vor dem Aushärten oder erst nach dem Aushärten elektrisch leitfähig ist. Vorzugsweise ist der Spezialklebstoff pastös, damit er vom Dispenser 111 in genau dosierten Mengen auf die Solarelemente 1 aufgebracht werden kann. Besonders geeignet ist ein Spezialklebstoff, der elektrisch leitende Metallpartikel umfasst. Bevorzugt ist ein herkömmlicher Silberleitkleber. Der Dispenser 111 kann je nach Anzahl der gewünschten parallelen Klebstoffbahnen eine, zwei oder mehr Klebstoffdüsen aufweisen. Alternativ kann aber auch eine Schlitzdüse eingesetzt werden, die eine entsprechende Anzahl von Austrittsöffnungen hat. In Fig. 1 ist der Dispenser 111 mit den Düsen in einen sich in y-Richtung erstreckenden Querbalken integriert.

Der Begriff "länglicher Leiter 2" wird hier verwendet für Leiterbahnen, Leiterbänder und Leiterstreifen. Der Querschnitt des länglichen Leiters 2 kann kreisförmig sein (Runddraht) oder halbrund, oval, quadratisch, recht-, sechs- oder achteckig. Vorzugsweise kommt eine flaches Leiterband mit rechteckigem Querschnitt als länglicher Leiter 2 zum Einsatz.

Als Material kommt vorzugsweise Kupfer zum Einsatz. Es sind aber auch Aluminium, Silber, Gold, Platin und Titanleiter geeignet. Es können auch die in der Halbleitertechnik gängigen Metalllegierungen als Leiter eingesetzt werden. Besonders bevorzugt wird ein verzinnter Kupferleiter.

Falls ein Kupferleiter zum Einsatz kommt, sollte dieser eine Festigkeit haben, die unterhalb von Rm = 250 N/mm² liegt. Bei Werten oberhalb von 250 N/mm² besteht beim Recken die Gefahr von Versprödung und Mikrorissbildung. Als Streckgrenze Re wird diejenige Zugspannung bezeichnet, bei der Fließen einsetzt, ohne dass die anliegende Zugspannung weiter erhöht wird. Der Begriff "recken" wird hier verwendet als Synonym für die Worte dehnen, strecken, langziehen, straffen.

Das Recken wird so vorgenommen, dass der Leiter 2 mit einer vorgegebenen Zugspannung in Längsrichtung beaufschlagt wird. Durch das Recken des Leiters 2 werden besonders vorteilhafte Leiteroberflächen erzeugt.

Vorzugsweise wird der Leiter 2 so gereckt, dass sich eine leichte plastische Verformung einstellt, um etwaige Welligkeiten des Leiters 2 zu beseitigen. D.h., das Recken geschieht so, dass die Streckgrenze Re minimal überschritten wird.

Vorzugsweise wird das Recken des Leiters 2 kontrolliert, indem das Recken in Prozent der Auszugslänge vor dem Recken definiert und die Verarbeitungsanlage 100 entsprechend eingestellt wird. Der Parameter für das Recken beträgt vorzugsweise zwischen 1 und 17% der Auszugslänge vor dem Recken. Besonders bevorzugt ist ein Parameter, der zwischen 1 und 5% liegt.

Das Recken des länglichen Leiters 2 wird überwacht, um das Überschreiten einer Zuggrenze K zu verhindern. Die Zuggrenze K kann auf unterschiedliche Art und Weise definiert werden. Im vorliegenden Fall dient der genannte Parameter als Zuggrenze K. Anstatt die Zuggrenze K als prozentuale Wegstrecke der Auszugslänge festzulegen, kann die Zuggrenze K z.B. auch als maximale Zugspannung definiert werden. Die maximale Zugspannung wird so festgelegt, dass das Recken des Leiters 2 in dem angegebenen Parameterbereich liegt. Die Zuggrenze K kann zum Beispiel auch als prozentuale Streckgrenze Re ausgedrückt werden. In diesem Fall beträgt die Zuggrenze K zwischen 100 und 117% der Streckgrenze Re. Vorzugsweise beträgt die Zuggrenze K zwischen 100 und 105% der Streckgrenze Re. D.h., die Zuggrenze K liegt etwas oberhalb der Streckgrenze Re.

Bei der 2. Station 120 wird die gewünschte Anzahl an länglichen Leitern 2 auf die Solarelemente 1 aufgebracht. In Fig. 1 ist eine Verarbeitungsanlage 100 gezeigt, wo in der 2. Station 120 zwei parallele längliche Leiter 2 aufgebracht werden.

Im gezeigten Beispiel sind die 3. und 4. Station 130, 140 identisch aufgeführt und dienen zum Aushärten des Spezialklebstoffs durch die von Infrarotstrahlern 131, 141 erzeugte Wärme. Statt der Infrarotstrahler 131, 141 können auch andere Heizquellen wie beispielsweise Induktionsspulen oder Widerstandsheizelemente eingesetzt werden.

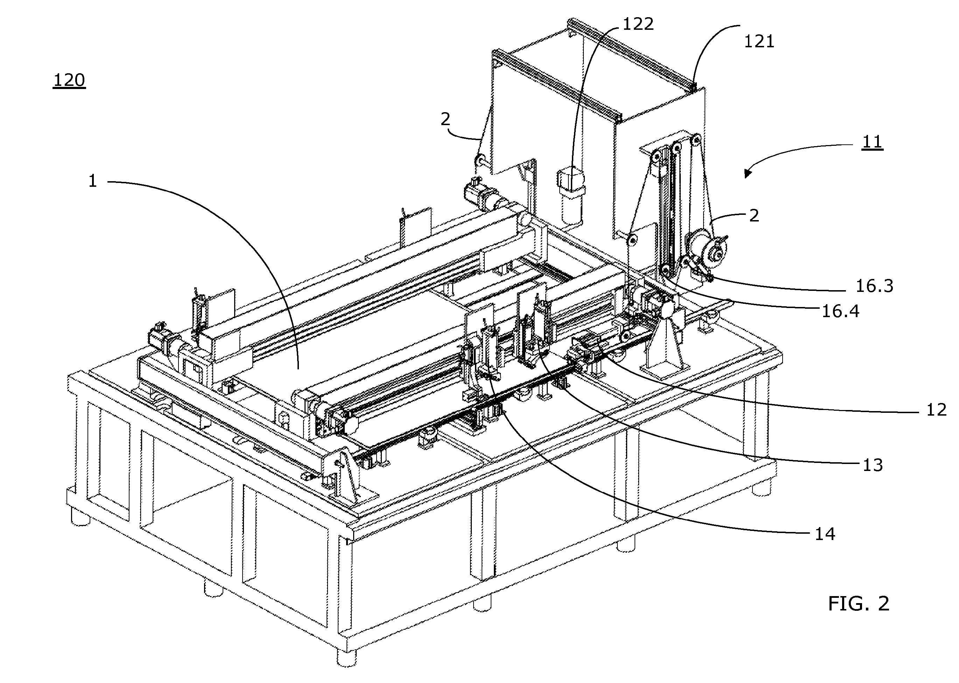

Fig. 2 zeigt Details der 2. Station 120 der ersten Ausführungsform der Erfindung. In der 2. Station 120 werden gleichzeitig zwei längliche Leiter 2 ausgezogen, gereckt, abgeschnitten und auf die Klebstoffbahnen aufgerollt. Die Klebstoffbahnen sind in den Figuren nicht zu erkennen. Bei der gezeigten ersten Ausführungsform sind die entsprechenden Elemente der 2. Station 120 symmetrisch aufgebaut. Die entsprechenden Elemente sind entlang beider Seitenkanten der Solarelemente 1 angeordnet. Die beiden länglichen Leiter 2 können zeitgleich auf die Solarelemente 1 aufgebracht werden.

Die erwähnten Elemente der 2. Station 120 werden im Folgenden näher erläutert. Die folgende Erläuterung erfolgt nur anhand der sichtbaren, auf der rechten Seite der Solarelemente 1 (in x-Richtung betrachtet) angeordneten Elemente und kann 1:1 übertragen werden auf die Elemente, die sich auf der linken Seite der 2. Station 120 befinden.

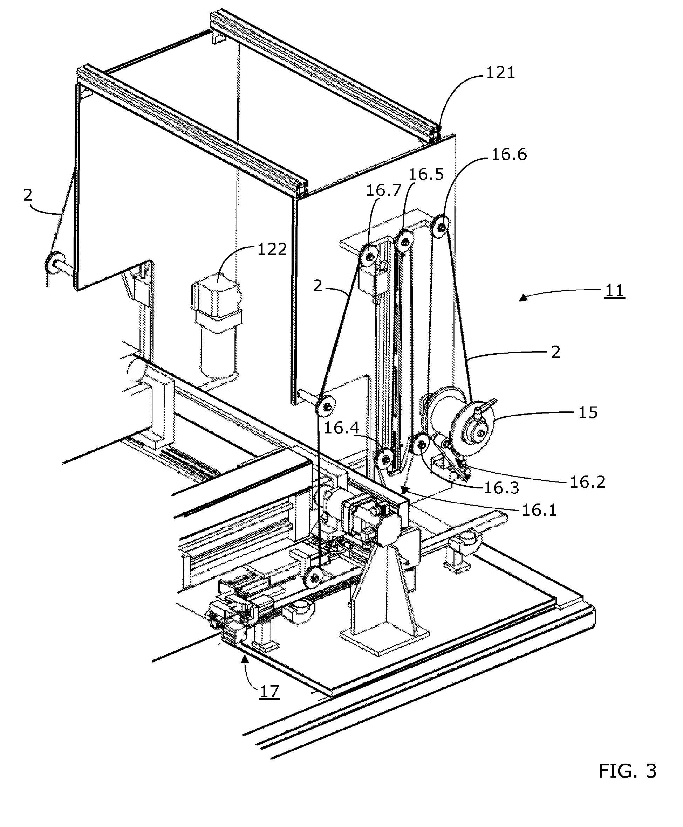

Es ist eine Bandzuführung 11 vorgesehen, um den länglichen Leiter 2 in ausreichender Länge zur Verfügung zu stellen. Die Bandzuführung 11 umfasst, wie in Fig. 3 näher gezeigt, eine Trommel 15 von der der Leiter 2 abgrollt werden kann. Der Leiter 2 wird von der Trommel 15 ausgehend schräg nach oben geführt. Dort verläuft der Leiter 2 um eine feststehende Umlenkrolle 16.6 senkrecht abwärts zu einer ersten Umlenkrolle 16.3 eines gewichtsbelasteten Tänzers 16.1. Von dort läuft der Leiter 2 erneut nach oben, wo er um eine feststehende Umlenkrolle 16.5 herum verläuft. Von dort gelangt der Leiter 2 erneut senkrecht nach unten um eine zweite Umlenkrolle 16.4 des Tänzers 16.1 herum. Von der zweiten Umlenkrolle 16.4 ausgehend verläuft der Leiter 2 erneut nach oben um eine feststehende Umlenkrolle 16.7 herum. Der Tänzer 16.1 mit seinen beiden Umlenkrollen 16.3 und 16.4 hängt in zwei Schlaufen des Leiters 2. Durch das Gewicht des Tänzers 16.1 (das Gewicht ist vorzugsweise einstellbar) wird der Leiter 2 stets gespannt. Ausserdem gleicht der Tänzer 16.1 Schwingungen aus, die beim Abrollen des Leiters 2 von der Trommel 15 entstehen könnten. Die Trommel 15 ist vorzugsweise motorisch angetrieben (ein entsprechender Trommelmotor 122 der linken Bandzuführung 11 ist in Fig. 2 und Fig. 3 zu erkennen). Die Trommel 15 kann auswechselbar ausgelegt sein. Es kann eine optionale Vorratsüberwachung 16.2 im Bereich der Trommel 15 angeordnet sein. Die rechte und die linke Bandzuführungen 11 können an einem Rahmen 121 oder Kasten befestigt sein, der die sich in x-Richtung bewegenden Solarelemente 1 überbrückt. Vorzugsweise sind vier Sensoren entlang des vertikalen Weges des Tänzers 16.1 angeordnet, um den Trommelmotor 122 der Trommel 15 zu regeln.

Durch den Einsatz eines Trommelmotors 122 wird sicher gestellt, dass beim Ausziehen des länglichen Leiters 2 die Zugspannung im Leiter 2 nicht zu hoch wird.

Insgesamt erlaubt die Bandzuführung 11 eine kontinuierliche und sichere Zuführung der erforderlichen Leiters 2.

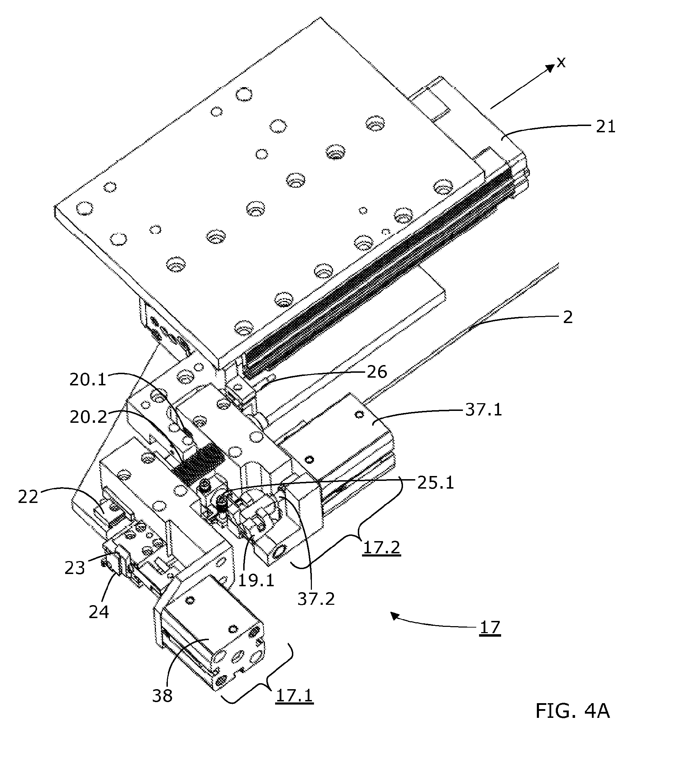

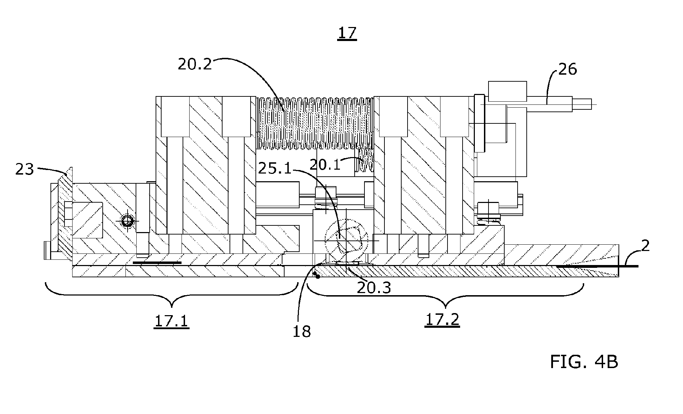

Als weiteres Element kommt eine Schneid-/Klemmeinheit 17 zum Einsatz, die in den Figuren 4A und 4B besser zu erkennen ist. Die Schneid-/Klemmeinheit 17 umfasst zwei Baugruppen. Die mit 17.1 bezeichnete Baugruppe wird hier auch Schneidkopf genannt und die mit 17.2 bezeichnete Baugruppe wird Klemmeinheit genannt. In den Figuren 4A und 4B ist zu erkennen, dass der längliche Leiter 2 von rechts (von der letzten Umlenkrolle der Bandzuführung 11 kommend) in die Klemmeinheit 17.2 hineinläuft.

Die Schneid-/Klemmeinheit 17 ist als ganzes mit einem Pneumatikschlitten 21 in x-Richtung beweglich. Vorzugsweise sind in x-Richtung zwei Stellungen der Schneid-/Klemmeinheit 17 vorgegeben. Der längliche Leiter 2 läuft, durch Führungsteile gehalten, unter einer Klemmplatte 18 durch, zu einem Schneidmesser 23. Die Klemmplatte 18 wird von Druckfedern 20.3 nach oben gedrückt oder, im Falle dass der längliche Leiter 2 geklemmt werden soll, von einem pneumatischen Klemmzylinder 37.1 mittels Kolbenstange 37.2, Gabel 19.1 und Exzenterwelle 25.1 nach unten auf den länglichen Leiter 2 gedrückt.

Das Schneidmesser 23 wird von dem pneumatischen Schneidzylinder 38 über eine Kulisse 24 betätigt. Klemmeinheit 17.2 und Schneidkopf 17.1 sind auf einer Linearführung 22 beweglich gelagert, wobei die Klemmeinheit 17.2 von einer 1. Druckfeder 20.1 und der Schneidkopf 17.1 von einer 2. Druckfeder 20.2 gegenüber dem Pneumatikschlitten 21 abgestützt werden. Ein optionaler Näherungssensor 26 detektiert die Lage der Schneid-/Klemmeinheit 17 und kann für die Rissüberwachung des länglichen Leiters 2 beim Recken (dieser Schritt wird später erläutert) verwendet werden.

In Fig. 4B ist in einer seitlichen Schnittansicht zu erkennen, dass durch ein Drehen der Exzenterwelle 25.1 die Klemmplatte 18 nach unten gedrückt wird. Die Druckfeder 20.3 bringt eine Gegenkraft auf. Durch das Nachuntendrücken der Klemmplatte 18 wird der längliche Leiter 2 festgeklemmt. Ausgelöst wird das Festklemmen durch eine translatorische Bewegung der Kolbenstange 37.2 in negativer x-Richtung. Diese translatorische Bewegung wird umgesetzt in eine Kippbewegung der Gabel 19.1 (siehe Fig. 4A). Die Kippbewegung verursacht eine Drehbewegung der Exzenterwelle 25.1. Diese Drehbewegung verursacht das Nachuntendrücken der Klemmplatte 18.

Die Schneid-/Klemmeinheit 17 dient also dem temporären einseitigen Festhalten des länglichen Leiters 2. Ausserdem kann die Schneid-/Klemmeinheit 17 den länglichen Leiter 2 durchtrennen, was durch eine Bewegung des Schneidmessers 23 erfolgt. Die Bewegung des Schneidmessers 23 erzeugt der pneumatische Schneidzylinder 38 (siehe Fig. 4A).

Zusätzlich zu der Schneid-/Klemmeinheit 17 sind ein sogenannter Auszugsschlitten 14 und ein sogenannter Anrollschlitten 13 vorgesehen.

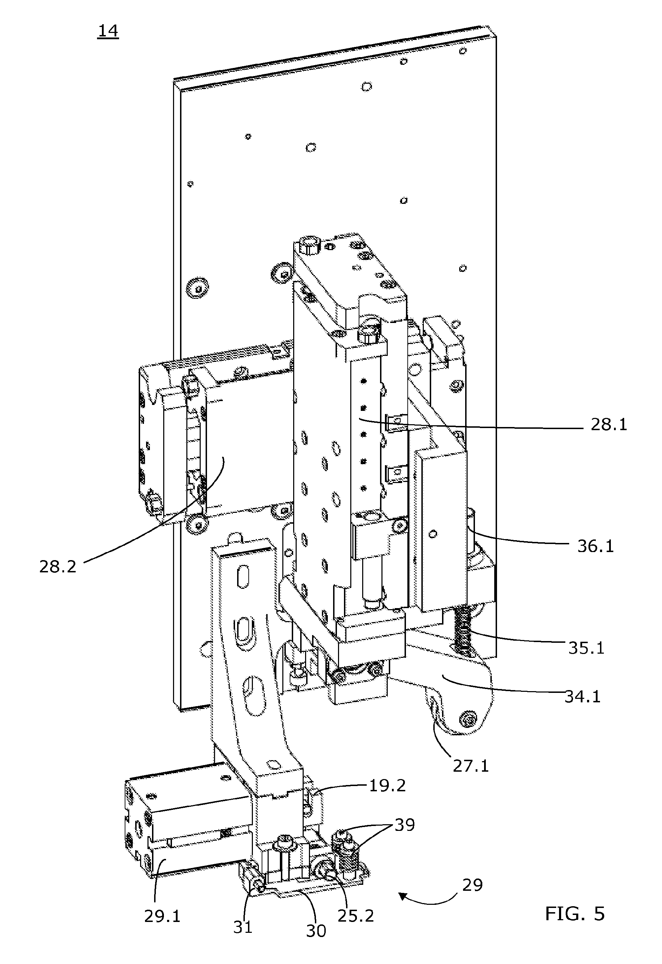

Der Auszugsschlitten 14 ist in der Fig. 5 gezeigt. Der Auszugsschlitten 14 verfügt über einen Greifer 29 zum temporären Fassen (Festklemmen) des länglichen Leiters 2 und eine gefedert gelagerte Andrückrolle 27.1. Die Andrückrolle 27.1 sitzt an einem Hebelarm 34.1, der über einen vertikalen Pneumatikschlitten 28.1 abgesenkt werden kann. Der Hebelarm 34.1 ist mit einer Federkraft einer Druckfeder 35.1 beaufschlagt und kann über einen Gewindebolzen 36.1 eingestellt werden. Die Andrückkraft in der unteren Stellung wird über die Druckfeder 35.1 aufgebracht, wobei die Federkraft durch Verändern der Vorspannung mit dem Gewindebolzen 36.1 eingestellt werden kann.

Der vertikale Pneumatikschlitten 28.1 ist seinerseits in x-Richtung durch einen horizontalen Pneumatikschlitten 28.2 verschiebbar. Der Greifer 29 ist ähnlich wie die Klemmeinheit 17.2 der Schneid-/Klemmeinheit 17 ausgeführt, wobei eine Klemmplatte 30, die um eine Schwenkachse 31 beweglich ist, von unten wirkt.

Der Greifer 29 des Auszugsschlittens 14 weist einen Pneumatikzylinder 29.1 auf, der mittels einer Kolbenstange (nicht sichtbar) eine translatorische Bewegung umsetzt in eine Kippbewegung einer Gabel 19.2. Die Kippbewegung wird übersetzt in eine Drehbewegung einer Exzenterwelle 25.2. Durch die exzentrische Bewegung der Exzenterwelle 25.2 wird die Klemmplatte 30 nach oben bewegt. Federn 39 drücken die Klemmplatte 30 nach unten.

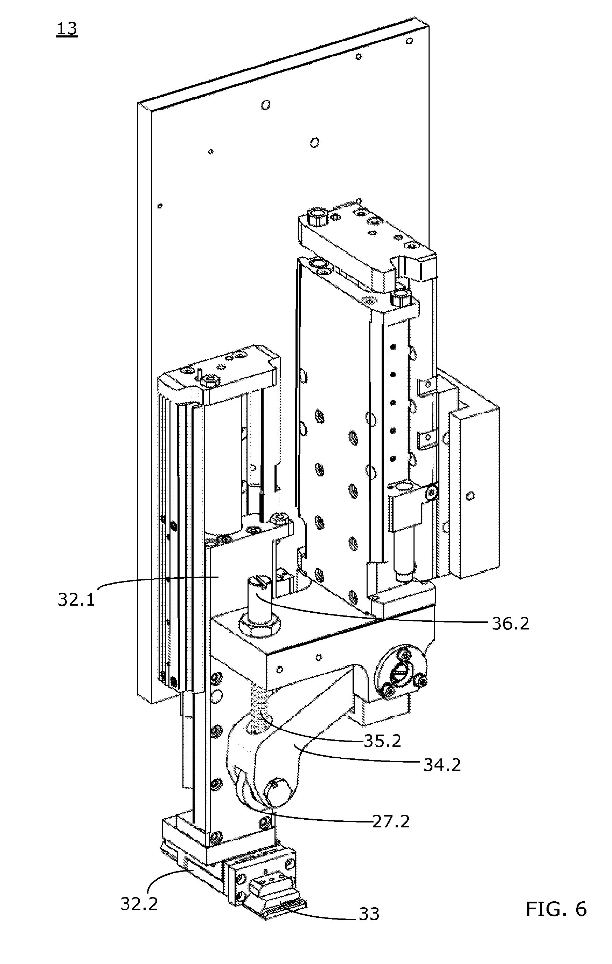

Der optionale Anrollschlitten 13 verfügt, wie in Fig. 6 gezeigt, ebenfalls über eine Andrückrolle 27.2, die jedoch in der gezeigten Ausführungsform nur vertikal beweglich befestigt ist. Wie beim Auszugsschlitten 14 ist die Andrückrolle 27.2 in einem Schwenkarm 34.2 gelagert. Die Andrückkraft in der unteren Stellung wird über eine Druckfeder 35.2 aufgebracht, wobei die Federkraft durch Verändern der Vorspannung mit dem Gewindebolzen 36.2 eingestellt werden kann.

Die Bandführung 33 des Anrollschlittens 13 kann mit einem vertikalen Pneumatikschlitten 32.1 (in z-Richtung wirkend) und dem in y-Richtung wirkenden horizontalen Pneumatikschlitten 32.2 unter den ausgezogenen länglichen Leiter 2 bewegt werden. Dabei wird zuerst die Bandführung 33 durch eine Bewegung in die negative z-Richtung abgesenkt und dann die Bandführung 33 durch eine horizontale Bewegung in negativer y-Richtung unter den länglichen Leiter 2 geschoben.

Vorzugsweise können die 1. und 2. Stationen 110, 120 in y-Richtung +/- 10 mm z.B. mit Mikrometerschrauben verstellt werden, um zum Beispiel eine Feinabstimmung vorzunehmen. Vorzugsweise können zusätzlich die Andrückrollen 27.1, 27.2 in y-Richtung relativ zu Greifer 29 bzw. Bandführung 33 verstellt werden.

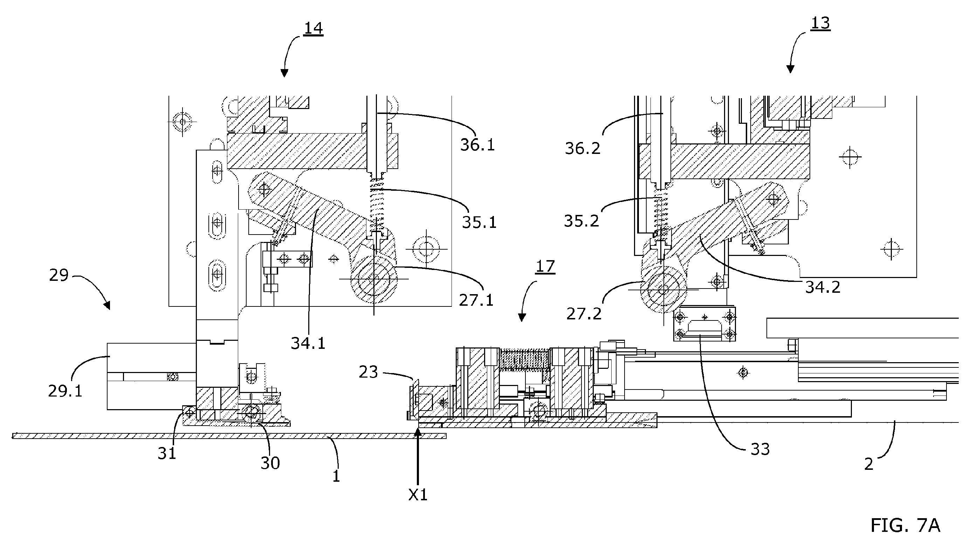

Nachdem nun die grundlegenden Elemente der 2. Station 120 beschrieben worden sind, wird in einzelnen Schritten das erfindungsgemässe Verfahren beschrieben. Die folgende Beschreibung und die Darstellungen in den Figuren 7A bis 7K beziehen sich auf eine besonders bevorzugte Ausführungsform der Erfindung. Das Verfahren kann aber auch mit weniger Schritten realisiert werden.

In Fig. 7A ist die Ausgangslage gezeigt. Das Solarelement 1, das mit mindestens einem länglichen Leiter 2 zu versehen ist, befindet sich unterhalb des Auszugsschlittens 14. Ein kurzes Endstück des länglichen Leiters 2 wird von der Schneid-/Klemmeinheit 17 gehalten. Der längliche Leiter 2 wurde in einem vorausgehenden Schritt (nicht gezeigt) abgetrennt und das Ende des länglichen Leiters 2 befindet sich am Ort X1.

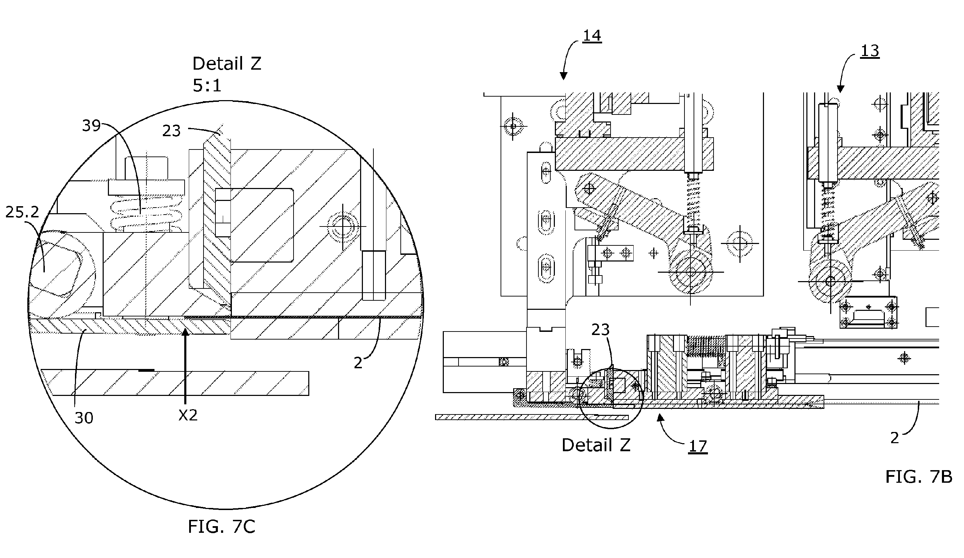

In einem zweiten Schritt, der in Fig. 7B dargestellt ist, wurde der Auszugsschlitten 14 in Richtung der Schneid-/Klemmeinheit 17 bewegt. Bei dieser Bewegung drückt der Auszugsschlitten 14 den Schneidkopf 17.1 der Schneid-/Klemmeinheit 17 zurück (in positiver x-Richtung), während der Pneumatikschlitten 21 ortsfest ist. Die Druckfeder 20.2 wird dabei zusammen gestaucht. Durch diese Rückbewegung des Schneidkopfs 17.1 wird ein Stück des freien Endes des länglichen Leiters 2 freigegeben, d.h. eine Stück des länglichen Leiters 2 ragt frei aus dem Schneidkopf 17.1 heraus. In der Ausschnittsvergrösserung (Detail Z) in Fig. 7C ist die Position des Endes des länglichen Leiters 2 mit X2 gekennzeichnet.

Der Greifer 29 des Auszugsschlittens 14 fasst nun das freie Ende des länglichen Leiters 2. Dies geschieht, indem der Pneumatikzylinder 29.1 eine Drehbewegung der Exzenterwelle 25.2 auslöst, wie beschrieben. Durch die exzentrische Bewegung der Exzenterwelle 25.2 wird die Klemmplatte 30 so bewegt, dass der längliche Leiter 2 eingeklemmt wird, wie in Fig. 7C gezeigt. Nun wird die Klemmeinheit 17.2 der Schneid-/Klemmeinheit 17 gelöst, d.h. das Festklemmen des Leiters 2 in der Klemmeinheit 17.2 wird aufgehoben.

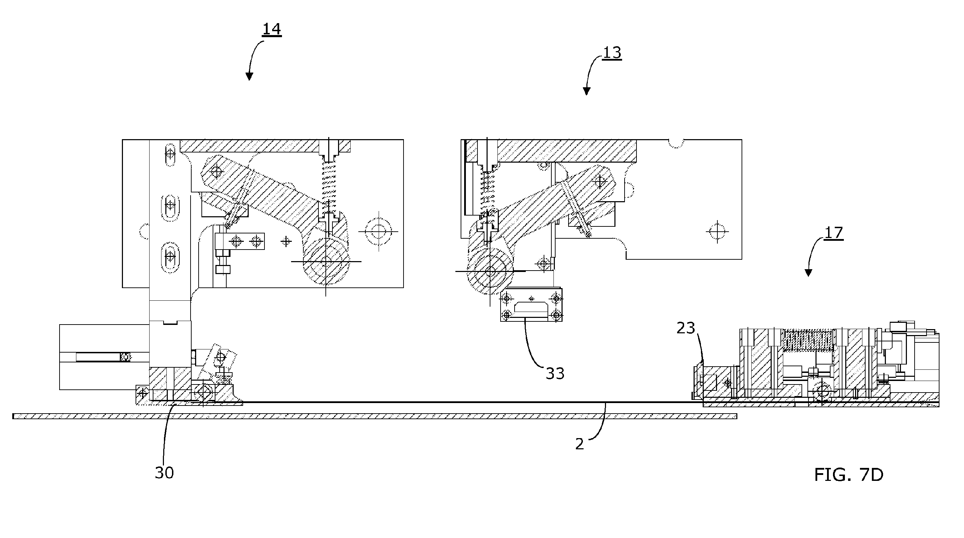

In einem nächsten Schritt, der in Fig. 7D gezeigt ist, bewegt sich der Auszugsschlitten 14 nach links (in negativer x-Richtung) und zieht damit den länglichen Leiter 2 heraus. Während dem Herausziehen des Leiters 2 läuft vorzugsweise der Trommelmotor 122, um die Trommel 15 zu mitzudrehen. Der Anrollschlitten 13 folgt dabei selbsttätig dem Auszugsschlitten 14 (dieser Schritt ist optional). Es sei hier angemerkt, dass die Strecke, die der Auszugsschlitten 14 in Bezug auf die Schneid-/Klemmeinheit 17 ausführt, deutlich grösser ist als die in Fig. 7D gezeigte Strecke. Vorzugsweise können Strecken von 300 mm bis zu 2000 mm zurückgelegt werden.

Anstatt den länglichen Leiter 2 durch eine translatorische Bewegung des Auszugsschlittens 14 herauszuziehen oder abzuwickeln, kann dieser Schritt in einer anderen Ausführungsform auch von der Schneid-/Klemmeinheit 17 ausgeführt werden, indem diese sich in negativer x-Richtung bewegt. Die Übergabe des freien Endes des Leiters 2 kann dann am Ende dieser Bewegung der Schneid-/Klemmeinheit 17 erfolgen. Das Bereitstellen des länglichen Leiters 2 kann auch durch eine Kombination von Bewegungen der Schneid-/Klemmeinheit 17 und des Auszugsschlittens 14 erfolgen.

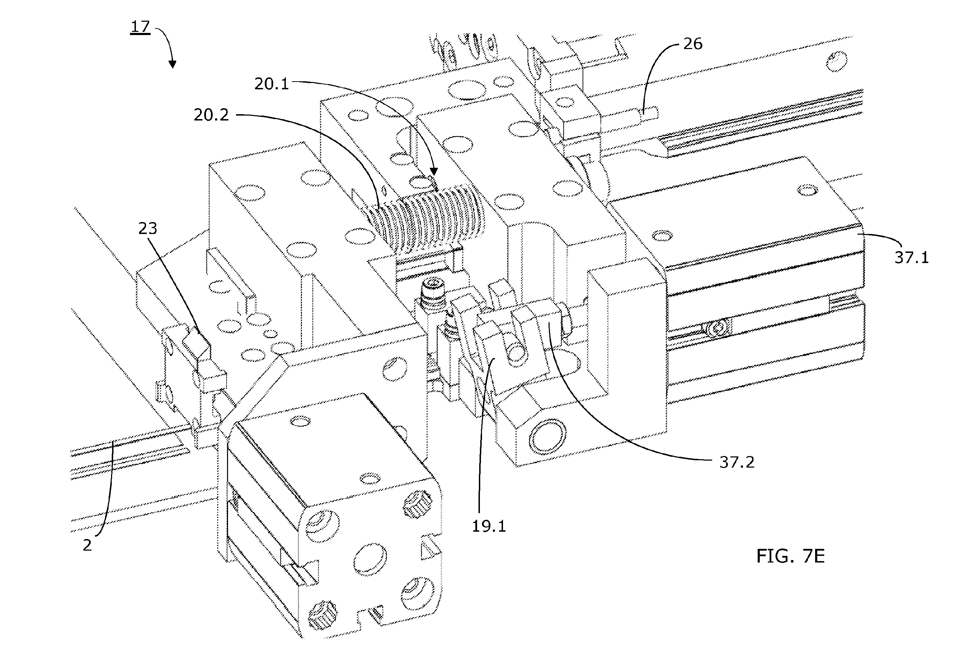

In einem nächsten Schritt, der in Fig. 7E gezeigt ist, wird der längliche Leiter 2 erneut in der Schneid-/Klemmeinheit 17 festgeklemmt. Das Festklemmen geschieht wiederum durch ein Betätigen des pneumatischen Klemmzylinders 37.1. Anschliessend wird der längliche Leiter 2 durch ein weiteres Ausfahren des Auszugsschlittens 14 gereckt. Dabei bewegt sich die Schneid-/Klemmeinheit 17, gezogen durch den länglichen Leiter 2, gegen die Federkraft der Druckfeder 20.1, weil der Pneumatikschlitten 21 in diesem Moment ortsfest ist. Die Druckfeder 20.1 wird bei diesem Schritt zusammen gedrückt, bis die Klemmeinheit an zwei Anschlägen (z.B. in Bohrungen eingepresste Gummizylinder) ansteht. Die Druckfeder 20.1 hat somit die Funktion, die Klemmeinheit 17.2 in Richtung des Näherungssensors 26 (d.h. in x-Richtung) zurückzustellen, wenn nicht gereckt wird. Falls der längliche Leiter 2 reissen sollte, würde die Klemmeinheit 17.2 durch die Druckfederkraft automatisch in Richtung des Näherungssensors 26 zurückgestellt. Damit kann ein Riss des Leiterbandes erkannt werden. Die Rissüberwachung erfolgt in diesem Ausführungsbeispiel durch den Näherungssensor 26, der diese Relativbewegung detektiert. Es können aber auch andere Mittel zur Rissüberwachung eingesetzt werden. Es kann zum Beispiel eine Widerstandsmessung des länglichen Leiters 2 durchgeführt werden, um anhand einer Widerstandsänderung eine Rissbildung oder das komplette Abreissen des Leiters 2 erkennen zu können. Es kann aber auch ein Kraftsensor (beispielsweise ein Piezoelement) eingesetzt werden, um die Zugspannung in dem länglichen Leiter 2 zu überwachen und um ein Durchtrennen detektieren zu können.

In einem nächsten Schritt, der nicht gezeigt ist, fährt der Auszugsschlitten 14 zurück (d.h. die zum Recken aufgebrachte Weglänge wird wieder zurück gefahren) bis der Näherungssensor 26 die Schneid-/Klemmeinheit 17 wieder in der Ausgangsposition detektiert. Durch diese Zwischenschritte wurde der längliche Leiter 2 kontrolliert gestreckt.

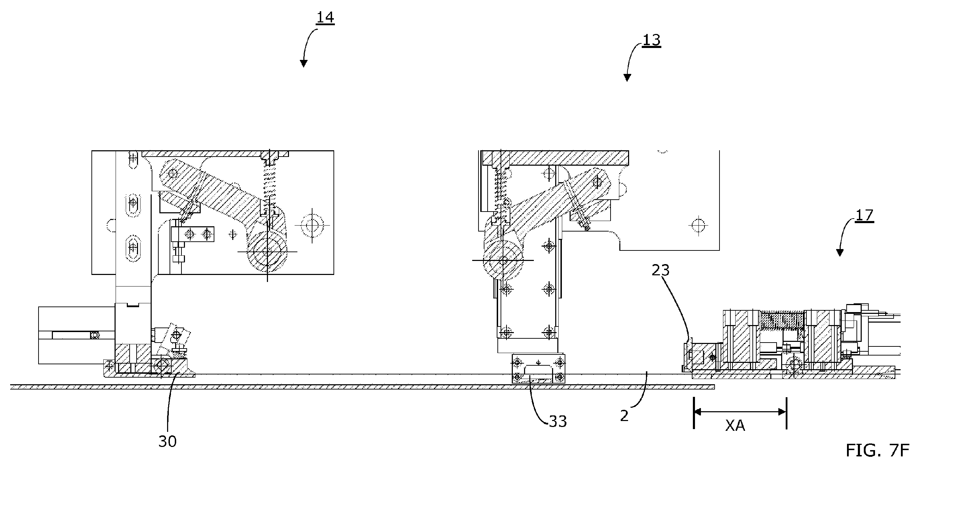

In einen nächstem Schritt, der in Fig. 7F gezeigt ist, wird die Klemmplatte 18 der Schneid-/Klemmeinheit 17 gelöst. Dann wird der längliche Leiter 2 weiter herausgezogen, indem sich der Auszugsschlitten 14 um eine Wegstrecke XA weiter nach links bewegt. Die Wegstrecke XA entspricht ungefähr dem Abstand zwischen der Klemmplatte 18 und dem Schneidmesser 23. Dieser Schritt wird vorzugsweise deswegen ausgeführt, weil der längliche Leiter 2 in keinem Bereich mehr als einmal gereckt werden darf. Alternativ kann in einem Zwischenschritt der entsprechende kurze Längenabschnitt des Leiters 2 (d.h. derjenige Längenabschnitt, der bereits gereckt wurde) abgetrennt und entfernt werden. Falls man das Herausziehen der Wegstrecke XA oder das Abtrennen des entsprechenden Längenabschnitts nicht ausführt, käme es beim nächsten Durchlaufen der erfindungsgemässen Schrittabfolge zu einem zweiten Recken des entsprechenden kurzen Längenabschnitts.

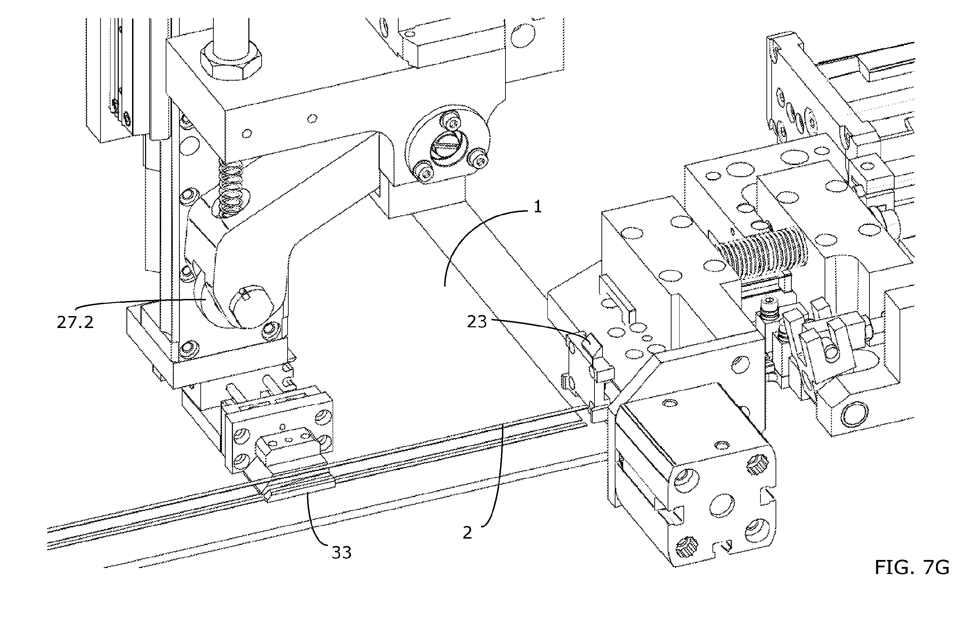

Nun wird in einem nächsten Schritt, der in Fig. 7G gezeigt ist, der längliche Leiter 2 wieder in der Schneid-/Klemmeinheit 17 festgeklemmt. Die Bandführung 33 des Anrollschlittens 13 fährt nun unter den ausgezogenen länglichen Leiter 2. Zu diesem Zweck kann die Bandführung 33 mit dem vertikalen Pneumatikschlitten 32.1 und dem in y-Richtung wirkenden horizontalen Pneumatikschlitten 32.2 bewegt werden.

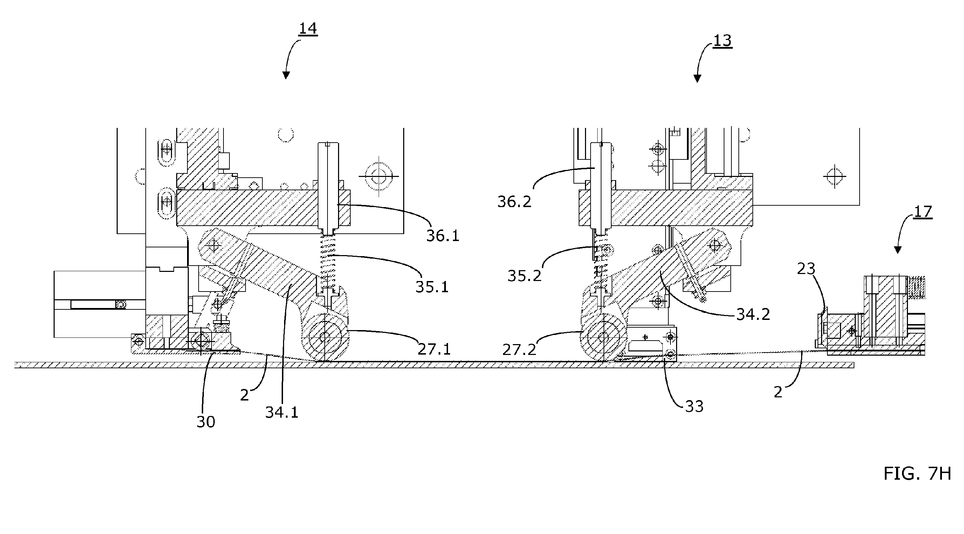

Nun werden, wie in Fig. 7H gezeigt, die Andrückrollen 27.1, 27.2 des Auszugsschlittens 14 und des Andrückschlittens 13 nach unten auf den länglichen Leiter 2 herabgesenkt. Die Andrückrolle 27.1 oder 27.2 werden vorzugsweise mittels pneumatischer Zylinder abgesenkt.

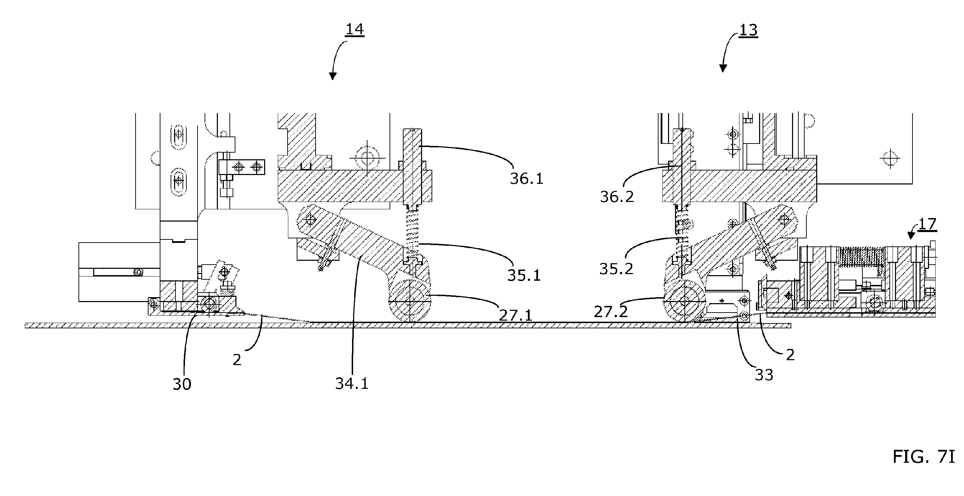

Dann fährt der Anrollschlitten 13 zurück bis zu der Schneid-/Klemmeinheit 17, wie in Fig. 7I gezeigt, um bei dieser Bewegung den länglichen Leiter 2 auf dem Solarelement 1 anzurollen. Der Verfahrweg ist dabei wesentlich länger als hier dargestellt. Parallel dazu wird die Andrückrolle 27.2 pneumatisch gegen die Schneid-/Klemmeinheit 17 verfahren, um das ausstehende Leiterstück zwischen den beiden Andrückrollen 27.1, 27.2 komplett anzurollen.

Dann fährt die Andrückrolle 27.1 des Auszugsschlittens 14 zurück und der Greifer 29 wird geöffnet, um das Ende des länglichen Leiters 2 frei zu geben.
Nun kann der längliche Leiter 2 mit dem Schneidmesser 23 abgetrennt werden.

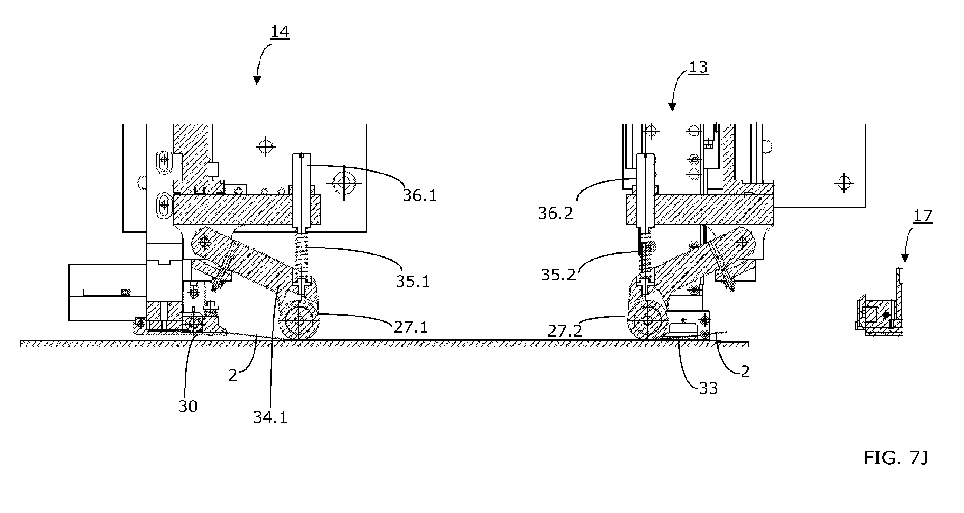

Jetzt, oder zu einem anderen geeigneten Zeitpunkt, kann die Schneid-/Klemmeinheit 17 zurück in die Ausgangsposition gefahren werden, wie in Fig. 7J angedeutet.

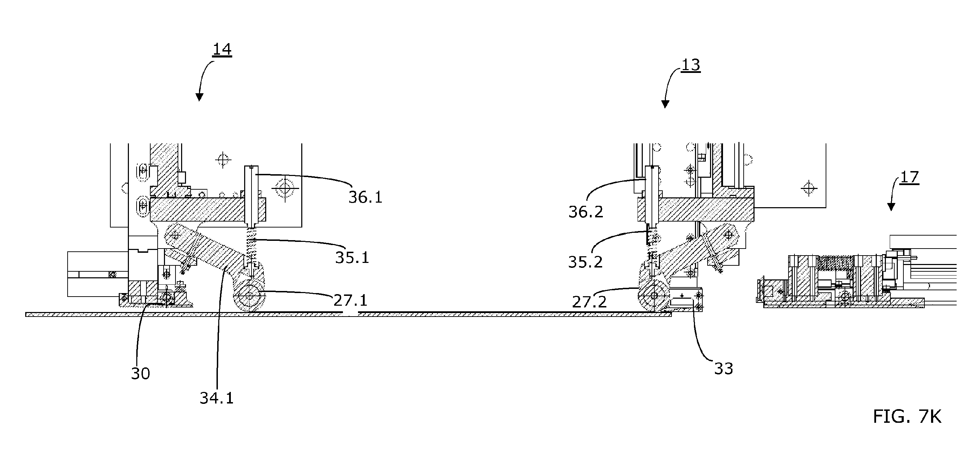

Abschliessend werden, falls erforderlich, die Endstücke des länglichen Leiters 2 mit den Andrückrollen 27.1, 27.2 angerollt, wie in Fig. 7K angedeutet.

Abschliessend werden die Andrückrollen 27.1, 27.2 angehoben und die einzelnen Elemente werden in die Ausgangsstellung bewegt. Vorzugsweise fährt die Schneid-/Klemmeinheit 17 voraus und die Auszugs- und Anrollschlitten 14, 13 folgen in ihre jeweiligen Ausgangspositionen nach.

Der erfindungsgemässe Auszugschlitten 14 erfüllt die folgenden Bedingungen:
- Er ist dazu ausgelegt den länglichen Leiter 2 vom Vorrat (Bandzuführung 11) zu entnehmen (abzuwickeln);
- Er ist mindestens in x-Richtung verfahrbar;
- Er ist optional in y-Richtung verfahrbar (für unterschiedlich breite Solarelemente 1);
- Er ist optional in z-Richtung verfahrbar (für unterschiedlich dicke Solarelemente 1);
- Er fährt um eine genau definierte Distanz weiter, um den länglichen Leiter 2 zu recken;
- Er hat mindestens eine Andrückrolle 27.1, um den länglichen Leiter 2 anzurollen.

Ausserdem kann der Auszugschlitten 14 vorzugsweise mit der Schneid-/Klemmeinheit 17 in mechanische Wechselwirkung treten, um ein Ende des Leiters 2 freizulegen und um dieses freie Ende mit dem Greifer 29 greifen zu können.

Der erfindungsgemässe Anrollschlitten 13 weist mindestens eine Andrückrolle 27.2 auf, um den länglichen Leiter 2 anzurollen. Vorzugsweise hat der Anrollschlitten 13 eine Bandführung 33. Der Einsatz eines solchen Anrollschlittens 13 ist optional. Das Anrollen kann auch komplett mit dem Auszugsschlitten 14 erfolgen, wobei sich diese Variante für kürzere Anrolllängen eignet, da sonst die Führungsfunktion des Anrollschlittens 13 fehlt.

Die Schneid-/Klemmeinheit 17 dient einerseits zum einseitigen Festhalten des länglichen Leiters 2 und weist andererseits Mittel auf, um den Leiter 2 abtrennen zu können. Vorzugsweise trägt die Schneid-/Klemmeinheit 17 einen oder mehrere Sensoren (z.B. den Näherungssensor 26), um das Recken des länglichen Leiters 2 zu überwachen.

In einer bevorzugten Ausführungsform wird an der Schneid-/Klemmeinheit 17 oder an dem Auszugschlitten 14 ein Sensor (vorzugsweise ein Dehnmessstreifen) zum Ermitteln der Zugspannung auf dem länglichen Leiter 2 eingesetzt.

Die Verarbeitungsanlage 100 ist so ausgelegt, dass der längliche Leiter 2 zielgenau auf die Spezialklebstoffspur abgesetzt und aufgerollt werden kann. Zum Schluss kann ein optionales Abdeckband über dem Leiter 2 ausgerollt werden. Das Abdeckband wird so aufgebracht, dass sichergestellt ist, dass sich keine eingeschlossene Luft unterhalb des Abdeckbands befindet.

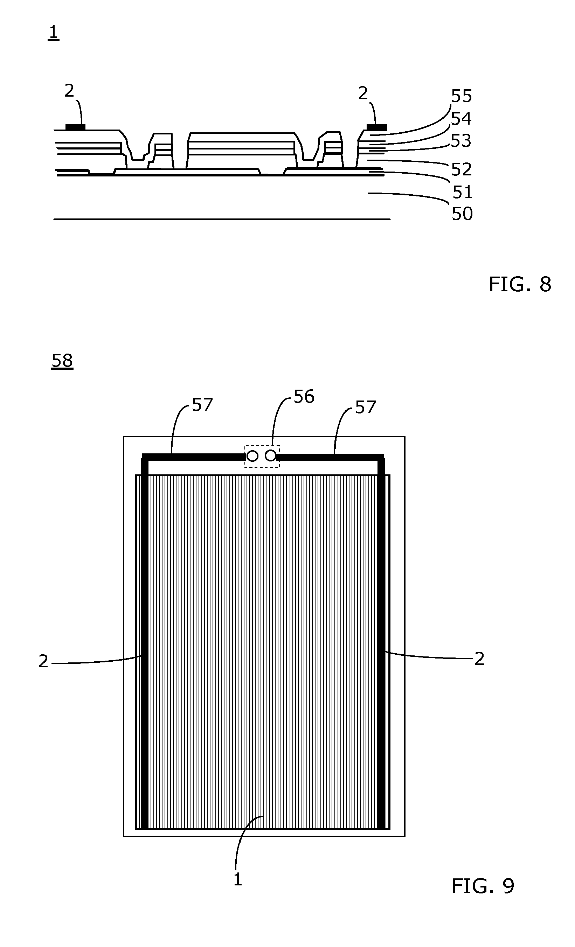

In Fig. 8 ist ein schematischer, nicht massstäblicher Schnitt durch ein Solarelement 1 gezeigt. Anhand dieser Schnittdarstellung ist der Schichtaufbau eines Solarelements 1 zu erkennen. Das gezeigte Solarelement 1 umfasst (von unten nach oben) ein Glassubstrat 50, auf dem eine Molybdänschicht 51 als Kontakt aufgebracht ist. Oberhalb der Molybdänschicht 51 befinden sich die Halbleiterschichten 52 und 53. Im vorliegenden Beispiel handelt es sich um eine CIGS-Schicht 52 und eine CdS-Schicht 53 (CIGS steht hier für Cu(In,Ga)Se₂ und CdS für Cadmiumsulfat) . Oberhalb dieser Halbleiterschichten 52 und 53 sind Kontaktschichten 54, 55 angeordnet, wobei es sich bei der Schicht 54 um eine i-ZnO-Schicht (intrinsische Zinkoxid Schicht) und bei der Schicht 55 um eine Zn:Al-Legierungsschicht (Zink-Aluminium Legierungsschicht) handelt. Auf der Schicht 55 befinden sich die Leiter 2, die mit dem erfindungsgemässen Verfahren aufgebracht wurden.

In Fig. 9 ist in einer schematischen, nicht massstäblichen Darstellung ein Solarmodul 58 mit einem Solarelement 1 gezeigt. Entlang der Seitenkanten des Solarelements 1 sind die länglichen Leiter 2 angeordnet. Weiterhin sind zwei quer verlaufende Leiterbahnen 57 vorgesehen, um die länglichen Leiter 2 mit einer Anschlussbox 56 zu verbinden. Die Leiterbahnen 57 und die Anschlussbox werden in einem gesonderten Arbeitsschritt angebracht. Das Solarmodul 58 kann zum Bespiel folgenden Dimensionen (Länge zu Breite) haben: 1300 mm x 1100 mm.

Die Erfindung lässt sich sowohl auf Vorderseiten- als auch auf Rückseitenkontaktierungen von Solarelementen 1 anwenden.

## Patentansprüche

1. Verfahren zum Aufbringen eines länglichen elektrischen Leiters (2) auf ein Solarelement (1) mit den folgenden Schritten:
- Bereitstellen einer vorherbestimmten Länge des länglichen elektrischen Leiters (2),
- Recken des länglichen elektrischen Leiters (2) durch Aufbringen einer Zugspannung,
- Befestigen des länglichen elektrischen Leiters (2) auf dem Solarelement (1),
**dadurch gekennzeichnet,**
- **dass** das Recken des länglichen elektrischen Leiters (2) überwacht wird, um ein Überschreiten einer Zuggrenze (K) zu verhindern, die oberhalb der Streckgrenze (Re) des länglichen elektrischen Leiters (2) liegt, und
- **dass** beim Befestigen mindestens eine Andrückrolle (27.1, 27.2) zum Anrollen des länglichen elektrischen Leiters (2) auf dem Solarelement (1) zum Einsatz kommt.

2. Verfahren nach Anspruch 1, **dadurch gekennzeichnet, dass** beim Bereitstellen ein freies Ende des länglichen elektrischen Leiters (2) von einer Klemmeinheit (17.2) festgeklemmt und durch eine translatorische Verschiebung der Klemmeinheit (17.2) von einer Trommel (15) abgewickelt wird.

3. Verfahren nach Anspruch 2, **dadurch gekennzeichnet, dass** die Trommel (15) motorisch angetrieben wird, um das Abwickeln zu unterstützen.

4. Verfahren nach einem der Ansprüche 1 bis 3, **dadurch gekennzeichnet, dass** beim Recken der längliche elektrische Leiter (2) an beiden Enden festgeklemmt wird, wobei ein Ende ortsfest festgeklemmt ist und das andere Ende in einem beweglich gelagerten Greifer (29) festgeklemmt ist.

5. Verfahren nach Anspruch 4, **dadurch gekennzeichnet, dass** der Greifer (29) eine translatorische Bewegung ausführt, um den länglichen elektrischen Leiter (2) zu recken, wobei eine Wegstrecke der translatorischen Bewegung vorgegeben ist.

6. Verfahren nach einem der Ansprüche 1 bis 5, **dadurch gekennzeichnet, dass** nach dem Recken der längliche elektrische Leiter (2) abgetrennt wird.

7. Verfahren nach Anspruch 1, **dadurch gekennzeichnet, dass** eine Bandführung (33) eingesetzt wird, um den länglichen elektrische Leiter (2) zu untergreifen und zu führen während der längliche elektrische Leiter (2) durch eine Andrückrolle (27.2) überrollt und angedrückt wird.

8. Vorrichtung (100) mit einer Station (120) zum automatisierten Aufbringen eines länglichen elektrischen Leiters (2) auf ein Solarelement (1), wobei die Vorrichtung (100) einen Auszugsschlitten (14) und eine Klemmeinheit (17.2), mit Mitteln (18, 20.3, 23.1, 23.2) zum temporären Festklemmen eines freien Endes des länglichen elektrischen Leiters (2), umfasst, **dadurch gekennzeichnet, dass**
- der Auszugsschlitten (14) einen Greifer (29) zum temporären Festklemmen eines freien Endes des länglichen elektrischen Leiters (2) und eine Andrückrolle (27.1) zum Überrollen und Andrücken aufweist, wobei vor dem Überrollen und Andrücken durch eine Bewegung des Greifers (29) der längliche elektrische Leiter (2) reckbar ist, und
- eine Einrichtung zur Überwachung einer Zuggrenze beim Recken des länglichen elektrischen Leiters (2) vorgesehen ist, um ein Überschreiten einer Zuggrenze (K) zu verhindern, die oberhalb der Streckgrenze (Re) des länglichen elektrischen Leiters (2) liegt.

9. Vorrichtung (100) nach Anspruch 8, **dadurch gekennzeichnet, dass** sie einen Anrollschlitten (13) umfasst, der eine weitere Andrückrolle (27.2) zum Überrollen und Andrücken sowie eine Bandführung (33) aufweist, wobei die Bandführung (33) unter den länglichen Leiter (2) fahrbar ist.

10. Vorrichtung (100) nach Anspruch 8, **dadurch gekennzeichnet, dass** der Greifer (29) eine über eine Exzenterwelle (25.2) betätigbare Klemmplatte (30) zum Festklemmen aufweist, wobei die Exzenterwelle (25.2) pneumatisch betätigbar ist.

11. Vorrichtung (100) nach einem der Ansprüche 9 oder 10, **dadurch gekennzeichnet, dass** die Andrückrollen (27.1, 27.2) pneumatisch absenkbar sind, wobei ein Anpressdruck beim Überrollen und Andrücken einstellbar ist.

12. Vorrichtung (100) nach einem der Ansprüche 8, 9, 10 oder 11, **dadurch gekennzeichnet, dass** die Baugruppe (17) die Klemmeinheit (17.2), eine Schneideinheit (17.1) und einen Antrieb (21) umfasst, wobei die Klemmeinheit (17.2) in Bezug auf den Antrieb (21) eine festgelegte translatorische Verschiebungsbewegung ausführen kann, während der Antrieb (21) ortsfest ist.

13. Vorrichtung (100) nach Anspruch 12, **dadurch gekennzeichnet, dass** die Baugruppe (17) eine Druckfeder (20.1) umfasst, die so angeordnet ist, dass bei der translatorischen Verschiebungsbewegung die Druckfeder (20.1) zusammengedrückt wird.

14. Vorrichtung (100) nach Anspruch 15, **dadurch gekennzeichnet, dass** an der Baugruppe (17) ein Sensor (26) vorgesehen ist, der ein Zurückschnellen der Klemmeinheit (17.2) in Bezug auf den Antrieb (21) detektiert.

15. Vorrichtung (100) nach Anspruch 9 in Kombination mit einem der Ansprüche 11 bis 14, **dadurch gekennzeichnet, dass** Auszugsschlitten (14) und Baugruppe (17) so ausgelegt sind, dass durch ein Annähern des Auszugsschlittens (14) an die Baugruppe (17) eine mechanische Wechselwirkung statt findet, die ein freies Ende des länglichen elektrischen Leiters (2) freilegt, das dann von dem Greifer (29) festgeklemmt werden kann.
